# EUROPEAN PATENT APPLICATION

(11) **EP 3 783 678 A1**
(43) Date of publication of application: **24.02.2021**
(21) Application number: 19192236.8
(22) Date of filing: 19.08.2019
(51) Int. Cl.: H01L 41/193

(54) **LAYERED ELECTRONIC DEVICE AND METHOD OF FORMING THE SAME**

(71) Applicant: Robert Bosch GmbH, 70442 Stuttgart (DE)
(72) Inventor: Jeon, Jin Han, 558962 Singapore (SG); Fook, Tony, 751589 Singapur (SG)

(57) **Abstract**

A layered electronic device is provided, including a conductive space-charge interlayer disposed between a first electroactive layer and a second electroactive layer; wherein the first electroactive layer and the second electroactive layer are disposed between a first electrode and a second electrode; and wherein the conductive space-charge interlayer is a metal nanostructure. Further, a method of forming a layered electronic device is provided, including providing a first electrode over a substrate; providing a first electroactive layer on the first electrode; providing a conductive space-charge interlayer on the first electroactive layer; providing a second electroactive layer on the first electroactive layer to form a sandwich structure; providing a second electrode on the second electroactive layer; wherein the conductive space-charge interlayer is a metal nanostructure.

## Description

### TECHNICAL FIELD

The present disclosure relates to a layered electronic device. The present invention further relates to a method of forming a layered electronic device.

### BACKGROUND

Dielectric materials are widely used in many applications such as energy storage (e.g. capacitors), energy harvesters, sensors and actuators and are traditionally inorganic material based (e.g. mica, silica). Since the 1950s, dielectric polymer technology has been rapidly evolving and currently biaxially oriented polypropylene (BOPP) dominates high energy density applications. In the research of dielectric polymers for high energy density applications, many new materials that exhibit significantly better energy density than BOPP have been reported. Other than high energy density, many of these new materials offer attractive properties such as good electromechanical and electrocaloric properties as well as their inverse effects for a wide variety of applications. These properties are highly dependent on the dielectric properties of the material. Hence, it is crucial to obtain excellent dielectric permittivity, polarizability and low dielectric loss in a dielectric material.

To enhance the dielectric properties of a material, there have been reports on enhancing the permittivity and consequently the polarizability of dielectric polymers. One common method to achieve this is by adding fillers to form composites. Fillers used include high *k* (dielectric permittivity) ceramic oxide fillers such as BaTiO₃, BST, TiO₂, etc. or highly conductive fillers such as nanofillers made of Au, Ag, Cu, CNTs, graphene, etc. However, fillers with a high dielectric permittivity and/or conductivity cause a local intensification of the electric field which leads to premature breakdown of the material.

### SUMMARY

It is an objective of the present invention to provide an improved electronic device.

Various embodiments may provide a layered electronic device. The layered electronic device may include a conductive space-charge interlayer disposed between a first electroactive layer and a second electroactive layer. The first electroactive layer and the second electroactive layer may be disposed between a first electrode and a second electrode. The conductive space-charge interlayer may be a metal nanostructure.

Various embodiments may provide a method of forming a layered electronic device. The method may include providing a first electrode over a substrate. The method may include providing a first electroactive layer on the first electrode. The method may include providing a conductive space-charge interlayer on the first electroactive layer. The method may include providing a second electroactive layer on the first electroactive layer to form a sandwich structure. The method may include providing a second electrode on the second electroactive layer. The conductive space-charge interlayer may be a metal nanostructure.

### BRIEF DESCRIPTION OF THE DRAWINGS

In the following description, various embodiments of the present disclosure are described with reference to the following drawings, in which:
FIG. 1 shows a schematic illustration of a cross section of a layered electronic device 100 according to various embodiments.
FIG. 2 shows a schematic illustration of a method 200 for producing a layered electronic device 100 according to various embodiments.
FIG. 3 shows a schematic illustration of a cross section of a layered electronic device 300 according to various embodiments.
FIG. 4 shows a graph 400 of the ferroelectric behavior of silver nanowire (AgNW) interlayer sandwiched ferroelectric electroactive polymer (FerroEAP) and neat FerroEAP films according to various embodiments.
FIG. 5 shows a graph 500 of the dielectric constant of AgNW interlayer sandwiched FerroEAP and neat FerroEAP films according to various embodiments.
FIG. 6 shows a graph 600 of the blocking force of a layered electronic device with and without AgNW interlayer according to various embodiments.

The figures are of schematic nature and elements therein may be of different scale or positioned differently to improve readability.

### DETAILED DESCRIPTION

The following detailed description describes specific details and embodiments in which the invention may be practiced. These embodiments are described in sufficient detail to enable those skilled in the art to practice the invention. Other embodiments may be utilized and changes may be made without departing from the scope of the invention. The various embodiments are not necessarily mutually exclusive, as some embodiments can be combined with one or more other embodiments to form new embodiments.

Features that are described in the context of an embodiment may correspondingly be applicable to the same or similar features in the other embodiments. Features that are described in the context of an embodiment may correspondingly be applicable to the other embodiments, even if not explicitly described in these other embodiments. Furthermore, additions and/or combinations and/or alternatives as described for a feature in the context of an embodiment may correspondingly be applicable to the same or similar feature in the other embodiments.

The invention illustratively described herein may suitably be practiced in the absence of any element or elements, limitation or limitations, not specifically disclosed herein. Thus, for example, the terms "comprising", "including," containing", etc. shall be read expansively and without limitation. The word "comprise" or variations such as "comprises" or "comprising" will accordingly be understood to imply the inclusion of a stated integer or groups of integers but not the exclusion of any other integer or group of integers. Additionally, the terms and expressions employed herein have been used as terms of description and not of limitation, and there is no intention in the use of such terms and expressions of excluding any equivalents of the features shown and described or portions thereof, but it is recognized that various modifications are possible within the scope of the invention claimed. Thus, it should be understood that although the present invention has been specifically disclosed by exemplary embodiments and optional features, modification and variation of the inventions embodied herein disclosed may be resorted to by those skilled in the art, and that such modifications and variations are considered to be within the scope of this invention.

The reference signs included in parenthesis in the claims are for ease of understanding of the invention and have no limiting effect on the scope of the claims.

The layered electronic device according to various embodiments may be an electroactive polymer (EAP) actuator. The EAP actuator may provide localized haptic feedback while having a fast response time.

The advantages of EAPs are that EAPs are lightweight, can be formed into any arbitrary shape, and are mechanically tough and flexible. Its flexibility is a significant advantage in light of the large focus on flexible electronics in recent years. Relaxor ferroelectric polymers, a class of EAPs, is highly transparent and exhibits high electric-field induced strain, making it excellent for flexible touch screen haptic applications. The electric-field induced strain of piezo- and ferroelectric materials depend strongly on the dielectric properties. Therefore, a high dielectric permittivity would enhance the electromechanical performance of such materials while a low dielectric loss signifies a low loss in energy when driving the material at varying electric field.

Conductive nanostructures such as metallic nanowires may be used as a space-charged interlayer to enhance dielectric properties of an electroactive polymer (EAP) film while maintaining electrical breakdown strength, transparency and flexibility of the modified film. Compared to adding nanomaterials into the polymer matrix to form composites, this has the advantage of not exhibiting the premature electrical breakdown when a voltage is applied across the material. A facile, cost and time efficient fabrication method that may be easily up-scaled for manufacturing a layered electronic device, for example, a transparent EAP thin film device with a conductive nanomaterial network interlayer to enhance actuator force output and displacement due to enhanced polarizability and dielectric constant arising from the conductive nanomaterial network layer.

Various embodiments provide a facile coating of nanoscale conductive materials sandwiched between electroactive layers which may drastically enhance the dielectric properties in the fabricated transparent thin films may be provided. Acting as a space charge layer, the nanomaterial network between active layers of the layered electronic device may enhances the polarizability, leading to higher dielectric constant of the material while maintaining a low dielectric loss. For example, conductive metallic nanowires may be used as the conductive space-charged interlayer to enhance dielectric properties of an EAP film while maintaining electrical breakdown strength, transparency and flexibility of the modified film.

Various embodiments provide a facile, cost and time efficient manufacturing process to fabricate a layered electronic device for example, a ferroelectric polymer actuators with conductive nanomaterial network interlayer to enhance actuator force output and displacement due to enhanced polarizability arising from the highly conductive nanomaterial network space-charged layer. According to various embodiments, conductive metal nanomaterials, for example AgNW may be used for their high conductivity, flexibility and transparency. Silver nanowires may have the advantage of possessing sheet resistance values and optical transparency close to that of a conventional transparent conductor (e.g., indium tin oxide (ITO)).

In various embodiments, the disclosed layered electronic device may be formed using standard thin film coating process (e.g. doctor blade, rod coating, bar coating, screen printing, slot die coating, spin coating, and roll to roll (R2R) coating) This may have the advantage of a facile, cost and time efficient manufacturing process as there is high compatibility with standard thin film coating process.

In various embodiments, patterning of areas with high and low dielectric permittivity may be possible by spatial control of the density of conductive nanomaterials and subsequently the degree of enhancement of dielectric permittivity and other properties.

In various embodiments, the disclosed layered electronic device may have an advantage of flexibility in producing various layered electronic devices e.g. haptic actuator designs like complex array or multi-stacked structures which may have an advantage of easily up-scaling the layered electronic device.

In various embodiments, the disclosed layered electronic device may have an advantage of enhanced dielectric permittivity while maintaining low dielectric loss and high breakdown strength.

In various embodiments, the disclosed layered electronic device may have an advantage of high optical transparency. The layered electronic device may have an optical transmittance of 90% to 99%.

In various embodiments, the disclosed layered electronic device may have an advantage of low haze. Haze may be the amount of light that is subjected to Wide Angle Scattering. Wide Angle Scattering may occur at an angle greater than 2.5° from normal (ASTM D1003). Materials with high haze may appear milky or cloudy. The layered electronic device may have a haze of less than 3%.

In various embodiments, the disclosed layered electronic device may have an advantage of high flexibility. The layered electronic device may have a range of bending radius from 4 mm to 10 mm. The layered electronic device, for example a fabricated actuator, may be bent to a bending radius of 4 mm while still functioning. In various embodiments, devices with a bending radius of less than 10 mm may be considered flexible. A bending radius of less than at least 5 mm may be required for rollable displays. The disclosed layered device, e.g. an actuator, which may withstand 4 mm bending radius may be applied to such technology. A bending radius of at least 5 mm is required for rollable displays, the disclosed layered electronic device, e.g., the actuator which may withstand 4 mm bending radius can be applied to such technology.

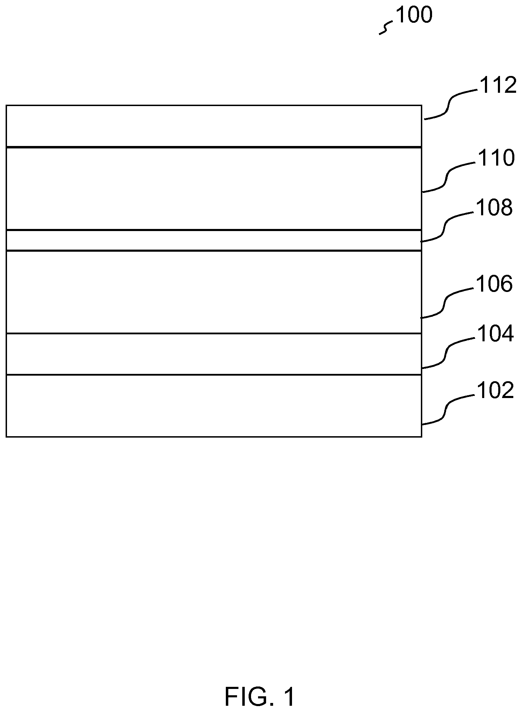

FIG. 1 shows a schematic illustration of a cross section of a layered electronic device 100 according to various embodiments.

The layered electronic device 100 may include a substrate 102. The layered electronic device 100 may include a first electrode 104 disposed on the substrate 102. The layered electronic device 100 may further include a first electroactive layer 106 disposed on the first electrode 104. The layered electronic device 100 may further include a conductive space-charge interlayer 108 disposed on the first electroactive layer 106. The layered electronic device 100 may further include a second electroactive layer 110 disposed on the conductive space-charge interlayer 108. The layered electronic device 100 may further include a second electrode 112 disposed on the second electroactive layer 110.

In various embodiments, the conductive space-charge interlayer 108 may be a nanostructure. In various embodiments, the conductive space-charge interlayer 108 may be a network of metal nanostructures. The conductive space-charge interlayer 108 may comprise of zero-dimensional (0D) nanostructures such as metallic nanoparticles or nanospheres. The conductive space-charge interlayer 108 may comprise of one-dimensional (1D) nanostructures such as metallic nanorods or nanowires. The conductive space-charge interlayer 108 may comprise of two-dimensional (2D) nanostructures such as nanosheets or nanogrids. In various embodiments, the metal nanostructure may comprise or consist of metal nanowires e.g. AgNW.

According to various embodiments, a layered electronic device 100 may include a conductive space-charge interlayer 108 which may be disposed between a first electroactive layer 106 and a second electroactive layer 110. In various embodiments, the first electroactive layer 106 and the second electroactive layer 110 may be disposed between a first electrode 104 and a second electrode 112.

According to various embodiments, the substrate may be a flexible substrate.

According to various embodiments, the substrate may be a transparent substrate.

According to various embodiments, the substrate may be a polymer substrate, for example selected from polyethylene terephthalate (PET), polyethylene naphthalate (PEN), polycarbonate (PC), which may further be flexible and/or transparent.

According to various embodiments, the layered electronic device may be a transparent device. Further, the layered electronic device may be a flexible device.

In various embodiments, the first and second electrodes may be transparent. In various embodiments, the first and second electrodes may exhibit high optical transmittance. In various embodiments, the first and second electrodes may be, for example individually selected from: ITO, AgNWs, graphene, and CNTs.

According to various embodiments, an electrical power, for example a voltage, may be provided to the first electrode and the second electrode.

In various embodiments, the first electrode and/or the second electrode may be either patterned or non-patterned.

**The** term "electroactive layer" may mean a layer which may undergo a shape change in response to an applied electrical field, which layer may further emit an electrical signal upon mechanical stimulation. The electrical signal may be detected via electrodes disposed on sides of the layer. The electroactive layer may include an electroactive material, e.g. an electroactive polymer. Within the context of the present disclosure and in accordance with various embodiments, an electroactive material, e.g., an electroactive polymer (EAP), is a material (a polymer in case of EAP) that undergoes shape change in response to an applied electrical field. Examples of electroactive materials may include: dielectric EAP (dEAP), piezo electric active polymer (piezoEAP). Examples of piezoEAPs are: FerroEAPs such as poly (vinylidenefluoride - trifluoroethylene - chlorotrifluoroethylene) abbreviated as P(VDF-TrFE-CTFE), poly(vinylidenefluoride-trifluoroethylene-chlorofluoroethylene) abbreviated as P(VDF-TrFE-CFE), poly(vinylidenefluoride - trifluoroethylene - hexafluoropropylene) abbreviated as P(VDF-TrFE-HFP), and poly[(vinylidenefluoride - co - trifluoroethylene] abbreviated as P(VDF-TrFE), poly[ (vinylidenefluoride - co - hexafluoropropylene] abbreviated as P(VDF-HFP), poly[ (vinylidenefluoride - co - chlorotrifluoroethylene] abbreviated as P(VDF-CTFE).

Examples of dielectric EAPs are: acrylic elastomers, silicon elastomers, fluoroelastomers, polyurethane, natural/synthetic rubbers.

In various embodiments, the first electroactive layer and/or the second electroactive layer may be either patterned or non-patterned.

In various embodiments, the first electroactive layer and the second electroactive layer may be the same material.

In various embodiments, the first electroactive layer and the second electroactive layer may be different materials.

According to various embodiments, the electrical power may not be provided to the conductive space-charged interlayer. In various embodiments, the conductive space-charge interlayer is free of external electronic connections, therefore the conductive space-charge interlayer is not an electrode.

According to various embodiments, the conductive space-charge interlayer may be coated on the first electroactive layer and the second electroactive layer may be coated on the conductive space-charge interlayer to form a sandwich structure.

In various embodiments, the provision of the conductive space-charge interlayer may result in charges accumulating at the interface between the first electroactive layer and the second electroactive layer, inducing a space-charge effect. This space charge effect may increase capacitance and dielectric properties of the layered electronic device.

According to various embodiments, heat may be applied on the conductive space-charge interlayer coated on the first electroactive layer.

According to various embodiments, pressure may be applied on the conductive space-charge interlayer coated on the first electroactive layer. There may be an advantage of dielectric breakdown strength by having better interfacial smoothness for example a lower interfacial roughness.

According to various embodiments, the conductive space-charge interlayer may be coated on the first electroactive layer by Mayer rod coating. In various embodiments, the conductive space-charge interlayer may be coated with a wet thickness of around 4 to 180 µm.

In various embodiments, depending on the concentration of nanomaterials in the solvent, the wet thickness used may be extremely small (for high concentrations of nanomaterials in solute) or extremely high (for low concentrations of nanomaterials in solute). In other coating process such as spin coating, the final dry thickness of the nanowire network may be dependent on the concentration of nanowire in solute and spinning speed (rpm). The conductive space-charge interlayer may be coated using RDS # Mayer rods. RDS # is the size of the feature / wire winding around the Mayer rod. For example, when # = 2, RDS 2 gives a wet thickness of 4.6 µm and when # = 5, RDS 5 give wet thickness of 11.4 µm. When coating AgNWs suspended in deionized (DI) water at a concentration of 0.5 wt% at a speed of 40 mm/s and using the RDS 2 Mayer rod, the amount of AgNW may be 1.46 µg AgNW per cm², and when using RDS 5 rod, the amount of AgNW may be 3.81 µg AgNW per cm². In various embodiments, fine tuning of the properties of the layered electronic device (e.g., dielectric permittivity, dielectric loss) may be carried out by adjusting the amount of metal nanowires per unit area.

According to various embodiments, the conductive space-charge interlayer may include metal nanowires e.g. AgNWs.

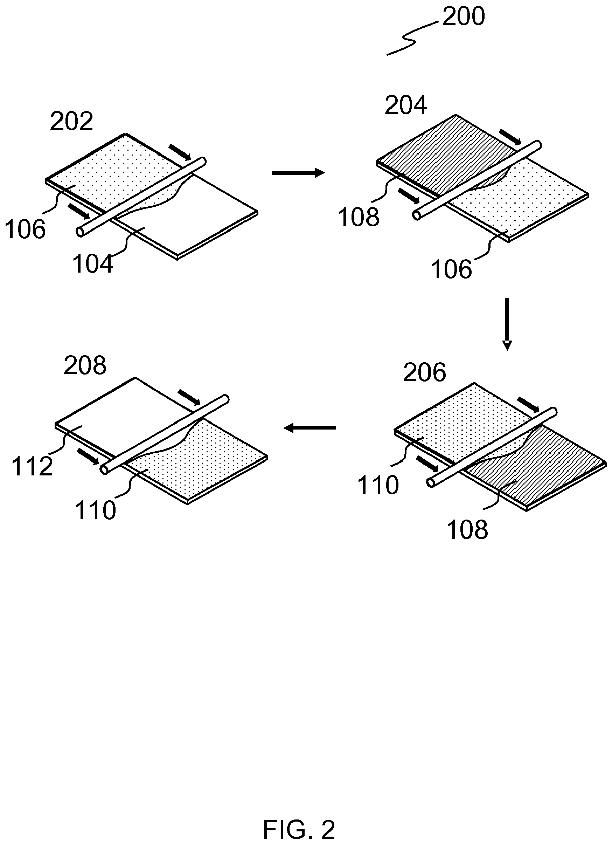

FIG. 2 shows a schematic illustration of a method 200 for producing a layered electronic device 100 according to various embodiments.

According to various embodiments, the method 200 of forming a layered electronic device may include disposing a conductive space-charge interlayer between a first electroactive layer and a second electroactive layer. In various embodiments, the method 200 may include disposing the first electroactive layer and the second electroactive layer between a first electrode and a second electrode. In various embodiments, the conductive space-charge interlayer may be a metal nanostructure.

According to various embodiments, the method 200 may include disposing a first electrode 104 disposed on a substrate 102 (not shown).

In various embodiments, the method 200 may include a first step 202 of disposing a first electroactive layer 106 on the first electrode 104. The first electroactive layer 106 may be coated on the first electrode 104 using any conventional thin film coating techniques. For example, the first electroactive layer 106 may be coated using techniques like doctor blade, rod coating, bar coating, screen printing, slot die coating, spin coating, roll to roll (R2R) coating and others. The first electroactive layer 106 may be any electroactive polymer (EAP) including piezoelectric, ferroelectric polymers, such as PVDF and its copolymers e.g., PVDF-TrFE, P(VDF-TrFE-CTFE), and P(VDF-TrFE-CFE). In various embodiments, the first electroactive layer 106 may be either patterned or non-patterned. A post-process may be conducted on the first electroactive layer 106. For example, drying and annealing process may be conducted to reinforce crystalline structure and ferroelectric properties of the first electroactive layer 106.

The method 200 may include a second step 204 of disposing a conductive space-charge interlayer 108 on the first electroactive layer 106. The conductive space-charge interlayer 108 may be a conductive nanomaterial network. The conductive space-charge interlayer 108 may be coated on the first electroactive layer 106. Any suitable coating techniques such as bar coating, spray coating, screen printing and others may be used to coat the conductive space-charge interlayer 108 on the first electroactive layer 106. Mayer rod coating technique may be used. The Mayer rod coating technique has an advantage of fast speed and ease of use. The solvent in nanomaterial solution may be chosen to avoid dissolving the active polymer layer coated upon, as dissolving the active polymer layer may destroy the crystallinity achieved by the previous post-processing process, for example the previous annealing process. The conductive space-charge interlayer 108 may be a metal nanostructure, for example, AgNWs and other metal nanowires, and nanogrids. The conductive space-charge interlayer 108 may be transparent.

In various embodiments, the conductive space-charge interlayer 108 may be treated to improve conductivity. In various embodiments, conventional heat treatment may be used to treat the conductive space-charge interlayer 108 to enhance the conductivity of the conductive nanomaterial network. The conductive space-charge interlayer 108 may be heated to 80 °C to 150 °C. The conductive space-charge interlayer 108 may be heated for 5 to 60 minutes. The conductive space-charge interlayer 108 may be heated for example to 110 °C for 15 minutes. Any other suitable temperature and/or time may be considered. In various embodiments, a facile hot press/roll technique may be employed to enhance the conductivity of the conductive space-charge interlayer 108. This has the advantage of short time needed for treatment. For example, the time needed may be in range of a few seconds, for example 5 to 60 seconds.

In various embodiments, the method 200 may include a third step 206 of disposing a second electroactive layer 110 on the conductive space-charge interlayer 108.

The second electroactive layer 110 may be coated on the conductive space-charge interlayer 108 using any conventional thin film coating techniques, like direct coating. For example, the second electroactive layer 110 may be coated using techniques like doctor blade, rod coating, bar coating, screen printing, slot die coating, spin coating, roll to roll (R2R) coating and others. The second electroactive layer 110 may be any electroactive polymer (EAP) including piezoelectric, ferroelectric polymers, such as PVDF and its copolymers e.g. PVDF-TrFE, P(VDF-TrFE-CTFE), and P(VDF-TrFE-CFE). In various embodiments, the second electroactive layer may be either patterned or non-patterned. The second electroactive layer 110 may be coated on the conductive space-charge interlayer 108 using polymer thin film transfer technique. In various embodiments, the polymer thin film transfer technique may include coating the electroactive polymer layer on glass and leaving to dry. In various embodiments, the polymer thin film transfer technique may include applying a silicone based material e.g., a silicone film, on top of coated electroactive polymer layer, and soaking in water. In various embodiments, the polymer thin film transfer technique may include detaching the silicone film attached to electroactive polymer film from glass substrate by submerging in water bath and drying the silicone and electroactive polymer film by heat. In various embodiments, the polymer thin film transfer technique may include applying pressure and heat to transfer the electroactive polymer film to the bottom electroactive polymer layer and the transparent conductive nanomaterial network. A facile method may be to use a hot roll laminator for transfer. In various embodiments, there may be no observed advantage in using film transfer compared to direct coating in terms of film quality, dielectric and ferroelectric properties.

In various embodiments, the method 200 may include a fourth step 208 of disposing a second electrode 112 on the second electroactive layer 110. The second electrode 112 may be coated on the second electroactive layer 110.

As a result of carrying out steps above, a conductive space-charge interlayer 108 which may be sandwiched by two electroactive layers 106, 110 may be fabricated and may be located between two electrodes 104, 112 in a layered electronic device 100.

In various embodiments, the conductive space-charge interlayer 108 may be patterned or deposited selectively, such that the conductive space-charge interlayer 108 is provided only in a region where the first electroactive layer 106 and the second electroactive layer 110 overlap.

In various embodiments, the device may be a layered electronic device, for example a capacitor, actuator, sensor, energy harvester, etc.

In various embodiments, the layered electronic device 100 may be transparent.

In various embodiments, the layered electronic device 100 may be flexible.

According to various embodiments, the layered electronic device 100 may include a plurality of conductive space-charge interlayers for example the first conductive space-charge interlayer and the second conductive space-charge interlayer. In various embodiments, each conductive space-charge interlayer for example, the first conductive space-charge interlayer and the second conductive space-charge interlayer, of the plurality of conductive space-charge interlayers may be disposed in between two electroactive layers. In various embodiments, the two electroactive layers with a conductive space-charge interlayer in between may be disposed between two electrodes.

According to various embodiments, the layered electronic device may include more than one conductive space-charge interlayer. The conductive space-charge interlayer 108 may be a first conductive space-charge interlayer and the layered electronic device 100 may include a second conductive space-charge interlayer to form a layered electronic device 300. This disclosure makes reference to the processing of a first conductive space-charge interlayer, but may also be applied to any (n)-th conductive space-charge interlayer. The number of electrodes may be (n+1). The layered electronic device may include more of such conductive space-charge interlayers to form a layered electronic device with multiple conductive space-charge interlayers.

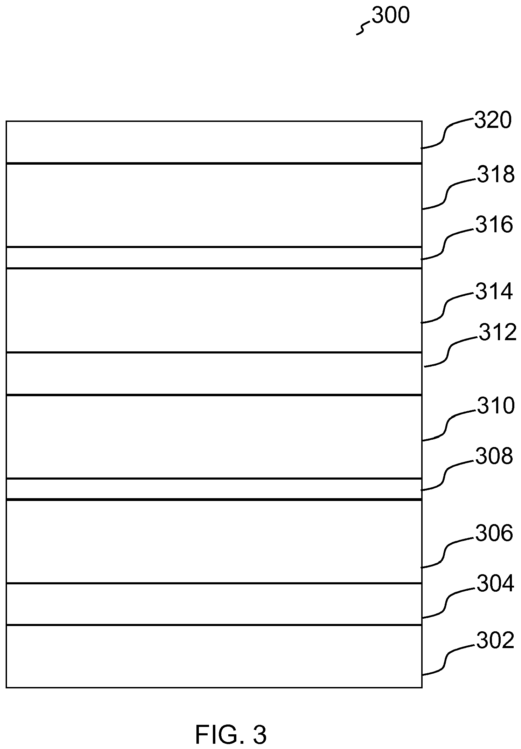

FIG. 3 shows a schematic illustration of a cross section of a layered electronic device 300 according to various embodiments.

According to various embodiments, the layered electronic device 300 may include a substrate 302. The layered electronic device 300 may include a first electrode 304 disposed on the substrate 302. The layered electronic device 300 may further include a first electroactive layer 306 disposed on the first electrode 304. The layered electronic device 300 may further include a conductive space-charge interlayer 308 disposed on the first electroactive layer 306. The layered electronic device 300 may further include a second electroactive layer 310 disposed on the conductive space-charge interlayer 308. The layered electronic device 300 may further include a second electrode 312 disposed on the second electroactive layer 310. The layered electronic device 300 may further include a third electroactive layer 314 disposed on the second electrode 312. The layered electronic device 300 may further include a second conductive space-charge interlayer 316 disposed on the third electroactive layer 314. The layered electronic device 300 may further include a fourth electroactive layer 318 disposed on the second conductive space-charge interlayer 316. The layered electronic device 300 may further include a third electrode 320 disposed on the fourth electroactive layer 318.The third electrode may be provided with similar method any may be of similar composition as explained above, in conjunction with the first electrode and the second electrode.

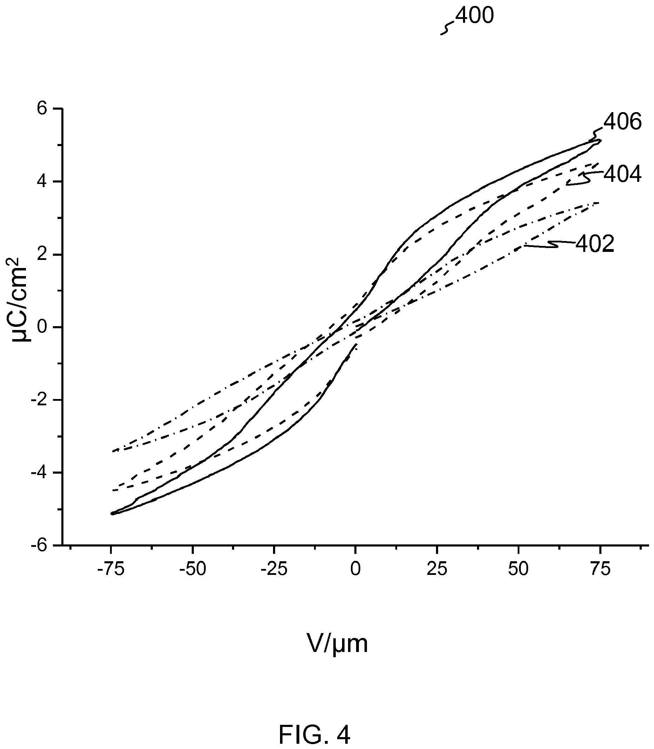

FIG. 4 shows a graph 400 of the ferroelectric behavior of a silver nanowire AgNW interlayer sandwiched ferroelectric electroactive polymer (FerroEAP) and neat FerroEAP films according to various embodiments.

In FIG. 4, the horizonal-axis of graph 400 represents the electric field (V/µm) and the vertical-axis represents polarization (µC/cm²).

In FIG. 4 the FerroEAP is a P(VDF-TrFE-CTFE) film. A curve 402 shows the ferroelectric behavior of a neat FerroEAP film without a silver nanowire AgNW interlayer. A curve 404 shows the ferroelectric behavior of a silver nanowire AgNW interlayer sandwiched FerroEAP coated using Mayer rods with 4.6 µm wet thicknesses (RDS 2) at coating speed of 40 mm/s. The silver nanowires AgNWs were suspended in DI water at a concentration of 0.5 wt%. A curve 406 shows the ferroelectric behavior of an AgNW interlayer sandwiched FerroEAP coated using Mayer rods with 11.4 µm wet thicknesses (RDS 5) at coating speed of 40 mm/s. The silver nanowires AgNWs were suspended in DI water at a concentration of 0.5 wt%. RDS # is the size of the feature / wire winding around the Mayer rod. For example, when # = 2, RDS 2 gives a wet thickness of 4.6 µm and when # = 5, RDS 5 gives wet thickness of 11.4 µm. The amount of AgNWs per unit area when coating with RDS 2 Mayer rod at stated process parameters is 1.46 µg AgNW per cm² and when coating with RDS 5 Mayer rod, the amount of AgNWs per unit area is 3.81 µg AgNW per cm².

As shown in FIG. 4, at an electric field strength of 75 V/µm, the maximum polarization of the film with sandwiched AgNW network coated by RDS 5 and RDS 2 Mayer rod was significantly higher than that of the neat polymer film (5.1 and 4.5 µC/cm² compared to 3.4 µC/cm² respectively).

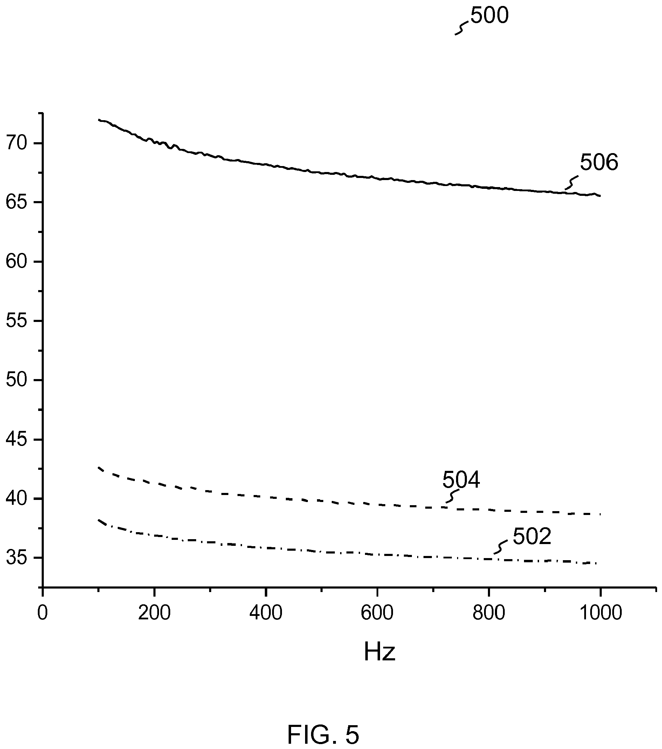

FIG. 5 shows a graph 500 of the dielectric constant of AgNW interlayer sandwiched FerroEAP and neat FerroEAP films according to various embodiments. In FIG. 5, the horizonal-axis of graph 500 represents frequency (Hz) and the vertical-axis represents dielectric constant.

A curve 502 shows the dielectric constant of the neat FerroEAP film. A curve 504 shows the dielectric constant of the AgNW interlayer sandwiched FerroEAP coated by RDS 2 Mayer rod. A curve 506 shows the dielectric constant of the AgNW interlayer sandwiched FerroEAP coated by RDS 5 Mayer rod.

As expected from the ferroelectric behavior of the films, the dielectric permittivity of the AgNW interlayer sandwiched film of 3.81 µg AgNW per cm² coated by RDS 5 Mayer rod is significantly higher than that of the neat polymer film at 65.5 and 34.5 at 1 kHz respectively as shown in FIG. 5. The dielectric permittivity of the AgNW interlayer sandwiched film of 1.46 µg AgNW per cm² coated by RDS 2 Mayer rod is at 38.7. An enhancement in dielectric properties of polymers may also exhibit an increase in dielectric loss by methods such as adding nanofillers to form composites. As shown in FIG. 4 and FIG. 5, even with a significant enhancement of dielectric permittivity and polarizability by 91% and 50% respectively, the dissipation of the fabricated AgNW interlayer sandwiched films maintained a low value of about 0.09 which is same as the neat polymer film without the conductive space-charged interlayer, indicating a high quality film with no increased dielectric loss compared to the neat polymer film.

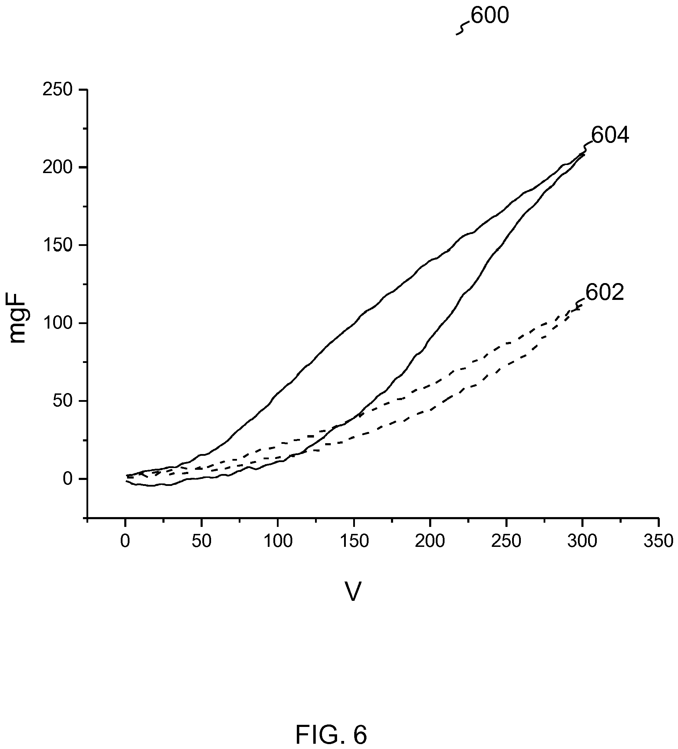

FIG. 6 shows a graph 600 of the blocking force of a layered electronic device with and without AgNW interlayer according to various embodiments. In FIG. 6, the horizonal-axis of graph 600 represents applied voltage (V) and the vertical-axis represents blocking force (mgF).

Furthermore, the EAP film with AgNW interlayer exhibited excellent optical properties. The optical transmittance at 550 nm wavelength was measured to be 91.6% and haze was at 1.3% for an EAP film with AgNW interlayer coated on PET substrate with RDS 2 Mayer rod while coating with RDS 5 rod produces an EAP film with transmittance of 90.4% and haze of 1.7%. For comparison, the optical transmittance and haze of the neat EAP film on PET substrate was 92.0% and 0.8% respectively, signifying only a very slight degradation in optical properties by incorporating the AgNW interlayer. The total thickness of the EAP film with AgNW interlayer is about 10µm.

FIG, 6 shows the blocking force of actuators with and without the AgNW interlayer. A curve 602 shows the blocking force without the AgNW layer and a curve 604 shows the blocking force with the AgNW layer. The AgNW interlayer was coated using RDS 5 Mayer rod with the parameters described above. The substrate used was 125 µm thick PET with ITO coated on it as the bottom electrode while transparent conductive polymer PEDOT:PSS was coated on top of the EAP film as top electrode. The actuators with and without the AgNW interlayer produced a blocking force of 2.059 mN (210 mgF) and 1.108 mN (113 mgF) respectively. The incorporation of the AgNW interlayer in the actuator enhanced the blocking force by ∼86% which is expected from the large enhancement of dielectric properties and polarizability.

The device and method disclosed herein may result in a facile, cost and time efficient fabrication technique for flexible and transparent EAP thin film devices, which may be, e.g. capacitors, actuators, sensors, or energy harvestors, with enhanced dielectric and ferroelectric properties.

## Claims

1. A layered electronic device (100) comprising:
a conductive space-charge interlayer (108) disposed between a first electroactive layer (106) and a second electroactive layer (110);
wherein the first electroactive layer (106) and the second electroactive layer (110) are disposed between a first electrode (104) and a second electrode (112); and
wherein the conductive space-charge interlayer (108) is a metal nanostructure.

2. The layered electronic device (100) of claim 1, wherein the conductive space-charge interlayer (108) comprises metal nanowires.

3. The layered electronic device (100) of claim 2, wherein the metal nanowires are silver nanowires.

4. The layered electronic device (100) of any one of claims 1 to 3, wherein the conductive space-charge interlayer (108) is a first conductive layer and the layered electronic device (100) further comprises:
a second conductive space-charge interlayer (316) disposed between a third electroactive layer (314) and a fourth electroactive layer (318), and
wherein the third electroactive layer (314) is disposed on the second electrode (112), and a third electrode (320) is disposed on the fourth electroactive layer (318).

5. The layered electronic device (100) of any one of claims 1 to 4, wherein the layered electronic device (100) is flexible.

6. The layered electronic device (100) of any one of claims 1 to 5, wherein the layered electronic device (100) is transparent.

7. The layered electronic device (100) of any one of claims 1 to 6, wherein the first electroactive layer (106) and the second electroactive layer (110) are the same material.

8. The layered electronic device (100) of any one of claims 1 to 6, wherein the first electroactive layer (106) and the second electroactive layer (110) are different materials.

9. The layered electronic device (100) of any one of claims 1 to 8, wherein the metal nanostructure comprises metal nanowires.

10. A method of forming a layered electronic device (100) comprising:
providing a first electrode (104) over a substrate (102);
providing a first electroactive layer (106) on the first electrode (104);
providing a conductive space-charge interlayer (108) on the first electroactive layer (106);
providing a second electroactive layer (110) on the first electroactive layer (106) to form a sandwich structure;
providing a second electrode (112) on the second electroactive layer (110);
wherein the conductive space-charge interlayer (108) is a metal nanostructure.

11. The method of claim 10, wherein heat is applied on the conductive space-charge interlayer (108) provided on the first electroactive layer (106).

12. The method of claim 10 or claim 11, wherein pressure is applied on the conductive space-charge interlayer (108) provided on the first electroactive layer (106).

13. The method of any one of claims 10 to 12, wherein the conductive space-charge interlayer (108) is coated on the first electroactive layer (106) by Mayer rod coating.
